# EUROPÄISCHE PATENTSCHRIFT

(11) **EP 2 215 636 B1**
(45) Veröffentlichungstag und Bekanntmachung des Hinweises auf die Patenterteilung: **23.07.2014**
(21) Anmeldenummer: 07822855.8
(22) Anmeldetag: 26.11.2007
(51) Int. Cl.: G11C 16/34

(54) **VERFAHREN ZUR GLEICHMÄßIGEN NUTZUNG MEHRERER FLASHSPEICHERCHIPS**
METHOD FOR EVEN UTILIZATION OF A PLURALITY OF FLASH MEMORY CHIPS
PROCÉDÉ D'UTILISATION SIMULTANÉE DE PLUSIEURS PUCES À MÉMOIRE FLASH

(43) Veröffentlichungstag der Anmeldung: 11.08.2010
(73) Patentinhaber: Hyperstone GmbH, 78467 Konstanz (DE)
(72) Erfinder: SCHMIDBERGER, Franz, 78464 Konstanz (DE)
(74) Vertreter: Reimann, Silke
(86) Internationale Anmeldenummer: PCT/EP2007/062785
(87) Internationale Veröffentlichungsnummer: WO 2009/068074

(56) Entgegenhaltungen:
- EP-A- 0 589 597
- US-A- 6 081 447
- US-A1- 2004 156 251

## Beschreibung

Die Erfindung betrifft ein Verfahren zum Adressieren eines Speichers mit mehren Flashspeicherchips, die in löschbare Blöcke gegliedert sind, die wiederum beschreibbare Sektoren enthalten, wobei das Schreiben eines Sektors nur in gelöschten Blöcken möglich ist und jeweils, wenn ein Sektorschreibbefehl auszuführen wäre, der einen bereits beschriebenen Sektor betrifft, durch eine geänderte Adressumsetzung in eine alternative Speicherblockadresse eines Speicherblocks, dessen entsprechender Sektor gelöscht oder unbeschrieben ist, in diesen geschrieben wird und falls jedoch dieser alternativ adressierte Sektor bereits beschrieben war, die Adressumsetzung eine weitere Speicherblockadresse eines zu löschenden Speicherblockes als eine neue alternative Speicherblockadresse bereitstellt und dessen entsprechender Sektor beschrieben wird, und im bisherigen alternativ adressierten Speicherblock die noch unbeschriebenen Sektoren mit den Inhalten der entsprechenden Sektoren des neu zugeordneten Speicherblocks beschrieben werden, und jedem Speicherblock ein Löschzähler zugeordnet ist.

Flashspeicherzellen haben die Eigenschaft, dass sie sich durch Löschen und Wiederbeschreiben allmählich abnutzen. Bei SLC-Flashes (single level cells) liegt die Lösch-Schreibhäufigkeit pro Zelle bei ca. 100.000 Operationen, bei MLC-Flashes (multi level cells) liegt sie bei ca. 10.000 Operationen, bevor Fehler auftreten.

Das Schreiben in einen Flashbereich ist dabei nur möglich, wenn dieser vorgelöscht ist. Dadurch sind sehr häufig Kopieroperationen notwendig.

Die Flashspeicherchips sind in vergleichsweise große Speicherblöcke gegliedert, die nur insgesamt löschbar sind. Ein solcher Block ist üblicherweise 128 kByte groß. Er ist weiter unterteilt in Sektoren von 512 Bytes (oder Pages von etwa 2 kBytes) in die jeweils geschrieben werden kann. Um Daten zu "überschreiben", wird stets ein gelöschter alternativer Speicherblock als Pufferblock auf dem Flash benutzt. Wenn nun z.B. Daten, die bisher nur in den Pufferblock geschrieben wurden, erneut überschrieben werden sollen, bedingt dieses das Auflösen des Pufferblocks und mithin das Kopieren aller unveränderten Sektoren des originalen Benutzerblockes.

Um die maximale Lebensdauer einer Flashkarte zu erreichen, müssen alle Flashspeicherzellen möglichst gleich häufig benutzt, also gelöscht und wieder beschrieben werden, unabhängig davon, welche Adressbereiche die jeweilige Anwendung gerade benutzt. So darf z.B. häufiges Überschreiben ein- und derselben Datei nicht dazu führten, dass immer wieder dieselben Flashspeicherblöcke verwendet werden.

Die Blöcke eines Flashspeichers werden über logische Blockadressen angesprochen, denen dann über eine Adresstransformationstabelle reale Speicherblockadressen zugeordnet werden. Durch Änderungen in der Tabelle können unterschiedliche reale Speicherblockadressen zu logischen Blockadressen genutzt und so eine Häufung von Löschoperationen auf einem realen Speicherblock vermieden werden.

Aus dem Patent US 6 145 051 ist ein Verfahren bekannt, bei dem über Adresstransformationstabellen zu jeder logischen Blockadresse eine erste physikalische, reale Speicheradresse eines Speicherblocks gehalten und dann eine weitere reale Speicherblockadresse eingestellt, wenn ein Sektor des ersten Speicherblocks mit neuer Information beschrieben werden sollte, der bereits beschrieben war, weswegen die neu zu schreibende Information in den Ausweichblock mit der weiteren Speicherblockadresse eingeschrieben wird, weil ein sofortiger Löschvorgang relativ sehr zeitaufwendig wäre und eine vermeidbare Abnutzung des Speicherblocks verursachen würde. Außerdem sind in der Adresstransformationstabelle Statusinformationen über die belegten/freien Sektoren und die Sektoren mit veraltetem Inhalt, die zu löschen sind, enthalten. Ein derartiges Tabellenwerk ist sehr platzaufwendig und muss wegen des häufigen und schnellen Zugriffs und wegen der ständigen Nachträge der Ausweichblockadressen und der notwendigen Umstrukturierung der Adressenzuordnung, wenn Blöcke umkopiert oder gelöscht worden sind, im Hilfsspeicher des Steuerprozessors gehalten werden, dessen Inhalt bei Stromausfall oder Abschaltung in den nichtflüchtigen Speicher gerettet werden muss.

Aus der Patentschrift DE 102 27 256 C1 ist ein Verfahren bekannt, bei dem jedem zu beschreibendem Block ein alternativer Block zugeordnet wird, in den zu überschreibende Sektoren geschrieben werden und falls ein Sektor ein weiteres Mal überschrieben werden soll, ein weiterer alternativer Block zugeordnet wird und alle nicht veränderten Sektoren aus dem ursprünglichen Block in den ersten alternativen Speicherblock kopiert werden. Dieses Kopieren erfolgt über einen Pufferspeicher in einem flüchtigen Speicherbereich. Jedem Speicherblock ist ein Zähler zugeordnet, der angibt, wie oft in den Speicherblock geschrieben wurde.

In der europäischen Patentanmeldung EP 0 589 597 A2 ist ein Flash-Speicher beschrieben, bei dem für jeden Speicherblock ein Löschzähler mitgeführt wird. Wenn ein weiterer gelöschter Block benötigt wird, wird der gesamte Speicher nach dem Block mit dem niedrigsten Löschzähler durchsucht. Bei großen Speichern wird dafür eine längere Suchzeit benötigt.

In dem Patent US 6,081,447 ist ein Verfahren zur gleichmäßigen Nutzung eines FlashSpeichers beschrieben. Dabei werden Gruppen von Blöcken zu Banks zusammengefasst und der Mittelwert der Nutzung dieser Bank mit anderen Banks verglichen. Wenn diese Mittelwerte sich deutlich unterscheiden, werden aufwendige Kopieroperationen durchgeführt. Die Nutzung .eines einzelnen Blockes wird nicht betrachtet.

In der Patentanmeldung US 2004/0156251 A1 ist ein Verfahren beschrieben, bei dem bei Lesefehlern aus einem Block der Block in einem Pufferspeicher erneut geschrieben wird und diese Schreibwiederholungen gezählt werden. Bei Überschreitung einer bestimmten Anzahl der Schreibwiederholungen wird dieser in einen anderen Speicherblock kopiert. Für eine gleichmäßige Nutzung der Speicherblöcke wird keine Sorge getragen.

Aufgrund der häufig notwendigen Kopieroperationen bieten viele neuere Flashspeicherchips die Möglichkeit, Sektoren oder Pages innerhalb des Flashchips von einem Block in einen anderen, vorgelöschten Block zu kopieren. Der hierfür zu verwendende Befehl heißt CopyBack und wird schnell ausgeführt. Er benutzt einen Pagepuffer, der direkt auf dem jeweiligen Flashchip liegt. Dieser CopyBack-Befehl ist somit nur für Kopiervorgänge innerhalb eines Flashspeicherchips nutzbar.

Der Nachteil der Nutzung dieses Befehles ist, dass sich auf verschiedenen Flashspeicherchips eines Speichers deutlich unterschiedliche Werte von Abnutzungen einzelner Blöcke ausbilden. Dieses führt dazu, dass auf einem der Flashspeicherchips alle Blöcke viel früher als auf anderen die möglichen Löschzyklen verbraucht haben werden. Diese lassen sich dann nicht mehr fehlerfrei beschreiben und müssen durch Ersatzblöcke ausgetauscht werden. Es steht aber nur eine relativ kleine Menge an Blöcken als Eratzblöcke zur Verfügung, in der Regel 2% der Gesamtblockanzahl. Nach dem Verbrauch der lokalen Ersatzblöcke würden permanente Fehler beim Schreiben und Löschen auftreten und die Karte könnte nicht mehr weiter beschrieben werden.

Es ist Aufgabe der Erfindung, ein Verfahren zu offenbaren, bei dem die Vorteile des schnellen Kopierens durch speicherchipinterne Befehle genutzt werden, aber auch ein gleichmäßiges Abnutzen aller Speicherblöcke eines Flashspeichers mit mehreren Speicherchips erreicht wird.

Diese Aufgabe wird mit den Merkmalen des Anspruchs 1 gelöst. Vorteilhafte Ausbildungen des Verfahrens sind in den Unteransprüchen angegeben.

Der CopyBack-Befehl ist ein interner Kopierbefehl und kann solange genutzt werden, wie die Kopiervorgänge von Sektoren aus einem Speicherblock in einen anderen Speicherblock lokal auf einem Chip vorgenommen werden können. Das Kopieren über diesen Befehl läuft sehr schnell und damit effektiv ab. Wenn aber der Löschzähler einen bestimmten Schwellwert für die Anzahl der Löschungen eines Blockes erreicht, werden die alternativen Speicherblöcke in allen Flashspeicherchips gesucht. Liegen diese Blöcke dann in anderen Speicherchips, werden die Sektoren über einen weiteren Pufferspeicher in einem zusätzlichen flüchtigen Speicher kopiert.

Um die Effektivität der Speicheroperationen möglichst lange auf einem hohen Wert zu halten, ist es günstig, den bestimmten Schwellwert, ab dem in allen Flashspeicherchips nach alternativen Blöcken gesucht wird, sehr hoch zu halten. So ist ein Schwellwert von etwa 90% der maximal zulässigen Löschhäufigkeit ein guter Wert, um lange eine hohe Effektivität des Speichers zu gewährleisten.

Die Zuordnung der realen Speicherblockadressen zu den logischen Adressen erfolgt über eine Zuordnungstabelle. In dieser Tabelle werden auch günstigerweise die Löschzähler mitgeführt. Die Auswertung des Löschzählers wird vereinfacht, indem der Löschzähler in einem höherwertigen und einen niederwertigen Teil aufgespaltet wird und zum Suchen der Speicherblöcke nur der höherwertige Teil überprüft wird. Dies verkürzt den Suchvorgang.

Das Suchen von alternativen Speicherblöcken in anderen Flashspeicherchips wird auch dann vorgenommen, wenn nicht mehr sichergestellt ist, dass die Adressumsetzung für alle logischen Blöcke auf dem gleichen Speicherchip erfolgt, also nicht mehr genügend gelöschte Blöcke vorhanden sind. Dies kann durch defekte Blöcke verursacht sein, deren Anzahl die Zahl der Reserveblöcke auf dem gleichen Chip überstiegen hat.

Eine Ausführungsform des Verfahrens ist in den Figuren beschrieben.
Fig. 1 zeigt eine beispielhafte Verteilung von Löschhäufigkeiten in einer Speicherkarte mit mehreren Flashchips ohne Einsatz des Verfahrens.
Fig. 2 zeigt ein Flussdiagramm für das Verfahren.

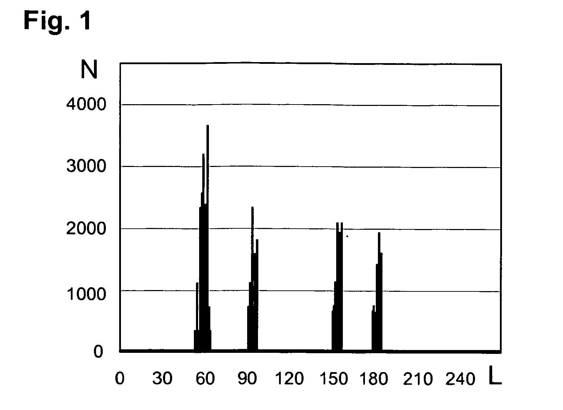

Die Fig. 1 zeigt eine Verteilung des höherwertigen Teils der Löschzählerstände L in einem Speicherchip, der Werte zwischen 0 und 255 annehmen kann. Dabei ist die Anzahl N der Blöcke mit einem Löschzählerstand L angegeben. Die Figur zeigt die Situation nach intensivem Gebrauch des Speichers. Es bilden sich Cluster von häufig gelöschten Speicherblöcken, wenn die Suche nach alternativen Speicherblöcken nur lokal auf dem Speicherchip erfolgt. Diese Clusterbildung wird aufgelöst, bzw. konvergiert zu einem einzigen Cluster, wenn die Suche über alle Speicherchips durchgerührt wird.

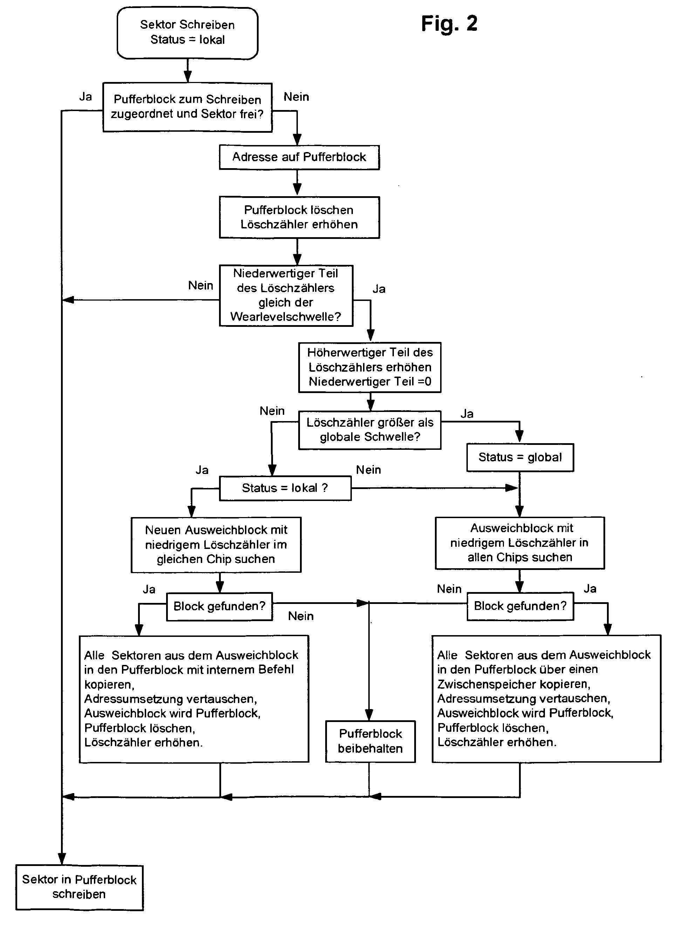

In Fig. 2 ist ein Flussdiagramm zu einer Ausführung des Verfahrens dargestellt. Ein Schreibbefehl für einen Sektor in einem Speicherblock liegt vor. Zunächst wird davon ausgegangen, dass der Status des Wearleveling so steht, dass eine lokale Suche nach freien Pufferblöcken durchgeführt werden kann. Falls Ein Pufferblock zum Schreiben zugeordnet ist und der zu beschreibende Sektor frei ist (den Inhalt nach einem Löschen besitzt), wird der Sektor geschrieben.

Falls der Sektor nicht frei ist, wird ein neuer Pufferblock adressiert. Dieser wird gegebenenfalls gelöscht und der Löschzähler erhöht. Nun wird geprüft, ob der niederwertige Teil des Löschzählers einer Wearlevelschwelle entspricht, die angibt, ab welcher Löschhäufigkeit eines Speicherblockes ein anderer Speicherblock genutzt werden soll. Falls diese Schwelle nicht erreicht wurde, wird der Sektor geschrieben. Falls die Wearlevelschwelle erreicht wurde, wird der höherwertige Teil des Löschzählers erhöht und der niederwertige Teil zurückgesetzt.

Nun wird überprüft ob der Löschzähler einen Schwellwert erreicht hat, ab dem in allen Speicherchips nach Blöcken mit einem niedrigen Löschzähler gesucht wird.

Im Falle dass dieser Schwellwert noch nicht erreicht wurde, wird nach einem Ausweichblock in dem gleichen Chip gesucht. Wenn dieser gefunden ist, werden alle Sektoren aus dem Ausweichblock mit dem internen CopyBack-Befehl in den Pufferblock kopiert. Durch Adressumsetzung werden die Blöcke getauscht, so dass aus dem Ausweichblock der neue Pufferblock wird. Dieser wird gelöscht und der Löschzähler erhöht. In diesen jetzt freien Pufferblock wird der Sektor geschrieben.

Falls durch die Erhöhung des höherwertigen Teils des Löschzählers der Schwellwert für die Suche in allen Speicherchips überschritten wurde, wird der Status des Wearleveling auf "global" gesetzt und in allen Speicherchips nach einem Ausweichblock mit niedrigem Löschzähler gesucht. Wenn dieser gefunden ist, werden alle Sektoren aus dem Ausweichblock über einen Zwischenspeicher, etwa in einem RAM-Bereich eines Speichercontrollers, in den Pufferblock kopiert. Durch Adressumsetzung werden die Blöcke getauscht, so dass aus dem Ausweichblock der neue Pufferblock wird. Dieser wird gelöscht und der Löschzähler erhöht. In diesen jetzt freien Pufferblock wird der

### Sektor geschrieben.

Falls die Suche nach einem Ausweichblock nicht erfolgreich ist, wird der Sektor in den noch aktuellen Pufferblock geschrieben. Dies ist nur der Fall, wenn die Speicherblöcke in allen Speicherchips schon einen entsprechend hohen Wert des höherwertigen Löschzählers besitzen.

Durch dieses Verfahren wird dafür Sorge getragen, dass sich ein Flashspeicher aus mehreren Chips insgesamt gleichmäßig abnutzt, dabei aber bis zu einem hohen Schwellwert die schnellen Kopiervorgänge innerhalb eines Chips genutzt werden.

## Patentansprüche

1. Verfahren zum Adressieren eines Speichers mit mehreren Flashspeicherchips, die in löschbare Blöcke gegliedert sind, die wiederum beschreibbare Sektoren enthalten, wobei das Schreiben eines Sektors nur in gelöschten Blöcken möglich ist und jeweils, wenn ein Sektorschreibbefeht auszuführen wäre, der einen bereits beschriebenen Sektor betrifft, durch eine geänderte Adressumsetzung in eine alternative Speicherblockadresse eines Speicherblocks, dessen entsprechender Sektor gelöscht oder unbeschrieben ist, in diesen geschrieben wird und falls jedoch dieser alternativ adressierte Sektor bereits beschrieben war, die Adressumsetzung eine weitere Speicherblockadresse eines zu löschenden Speicherblockes als eine neue alternative Speicherblockadresse bereitstellt und dessen entsprechender Sektor beschrieben wird, und im bisherigen alternativ adressierten Speicherblock die noch unbeschriebenen Sektoren mit den Inhalten der entsprechenden Sektoren des neu zugeordneten Speicherblocks beschrieben werden, und jedem Speicherblock ein Löschzähler für die Anzahl seiner Löschungen zugeordnet ist,
**dadurch gekennzeichnet,**
**dass** bis zum Erreichen eines bestimmten Schwellwertes eines Löschzählers bei jeder Bereitstellung eines alternativen Speicherblocks der Speicherblock auf dem gleichen Flashchip mit einem niedrigen Wert des Löschzählers gesucht wird, bei Überschreiten des bestimmten Schwellwertes in allen Flashspeicherchips nach einem Speicherblock mit einem niedrigen Wert des Löschzählers gesucht wird und der gefundene Speicherblock als alternativer Speicherblock zur Verfügung gestellt wird.

2. Verfahren nach Anspruch 1, **dadurch gekennzeichnet, dass** bei dem Kopieren von Sektoren in einen alternativ adressierten Speicherblock innerhalb des gleichen Flashchips ein interner Kopierbefehl benutzt wird.

3. Verfahren nach Anspruch 1, **dadurch gekennzeichnet, dass** bei dem Kopieren von Sektoren in einen alternativ adressierten Speicherblock außerhalb des gleichen Flashchips ein weiterer Pufferspeicher benutzt wird.

4. Verfahren nach Anspruch 1, **dadurch gekennzeichnet, dass** der bestimmte Schwellwert bei etwa 90% der maximal zugelassenen Löschhäufigkeit liegt.

5. Verfahren nach Anspruch 1, **dadurch gekennzeichnet, dass** die Adressumsetzung über eine Zuordnungstabelle von logischen zu realen Speicherblockadressen erfolgt, in der auch die Löschzähler gerührt werden.

6. Verfahren nach Anspruch 1, **dadurch gekennzeichnet, dass** der Löschzähler eines Speicherblockes in einen niederwertigen und einen höherwertigen Teil getrennt ist und nur der höherwertige Teil zum Suchen der alternativen Speicherblöcke genutzt wird.

7. Verfahren nach Anspruch 1, **dadurch gekennzeichnet, dass** auch dann in allen Flashspeicherchips nach einem alternativen Speicherblock mit einem niedrigen Wert des Löschzählers gesucht wird, wenn auf dem gleichen Flashspeicherchip kein weiterer gelöschter Block als Pufferblock mehr verfügbar ist.

## Claims

1. Method for addressing a memory having a plurality of flash memory chips divided into erasable blocks which in turn contain writable sectors, wherein it is possible to write to a sector only in erased blocks and, if it is necessary to execute a sector write command relating to a sector which has already been written to, changed address translation to an alternative memory block address of a memory block whose corresponding sector has been erased or has not been written to respectively results in said sector being written to and, if this alternatively addressed sector has already been written to, however, the address translation provides a further memory block address of a memory block to be erased as a new alternative memory block address and its corresponding sector is written to, and the contents of the corresponding sectors of the newly allocated memory block are written to the sectors which have not yet been written to in the previous alternatively addressed memory block, and each memory block is assigned an erase counter for the number of times it is erased,
**characterized in that**
each time an alternative memory block is provided, the memory block on the same flash chip with a low value of the erase counter is sought until a particular threshold value of an erase counter is reached, and a memory block with a low value of the erase counter is sought in all flash memory chips if the particular threshold value is exceeded and the memory block found is provided as an alternative memory block.

2. Method according to Claim 1, **characterized in that** an internal copying command is used when copying sectors to an alternatively addressed memory block inside the same flash chip.

3. Method according to Claim 1, **characterized in that** a further buffer memory is used when copying sectors to an alternatively addressed memory block outside the same flash chip.

4. Method according to Claim 1, **characterized in that** the particular threshold value is approximately 90% of the maximum permitted erase frequency.

5. Method according to Claim 1, **characterized in that** the address translation from logical memory block addresses to real memory block addresses is carried out using an allocation table in which the erase counters are also managed.

6. Method according to Claim 1, **characterized in that** the erase counter of a memory block is divided into a low-order part and a higher-order part and only the higher-order part is used to search for the alternative memory blocks.

7. Method according to Claim 1, **characterized in that** an alternative memory block with a low value of the erase counter is also sought in all flash memory chips when a further erased block is no longer available as a buffer block on the same flash memory chip.

## Revendications

1. Procédé pour adresser une mémoire comprenant plusieurs puces de mémoire flash qui sont divisées en blocs effaçables, lesquels contiennent à leur tour des secteurs inscriptibles, dans lequel l'écriture d'un secteur n'est possible que dans les blocs effacés et à chaque fois qu'il faudrait exécuter une instruction d'écriture de secteur qui concerne un secteur déjà écrit, par une transposition d'adresse modifiée dans une adresse de bloc de mémoire alternative d'un bloc de mémoire dont le secteur correspondant est effacé ou non écrit, l'écriture est effectuée dans ce secteur, et dans le cas où ce secteur adressé en alternative était tout de même déjà écrit, la transposition d'adresse fournit une adresse de bloc de mémoire supplémentaire d'un bloc de mémoire à effacer en tant que nouvelle adresse de bloc de mémoire alternative et l'écriture est effectuée dans son secteur correspondant, et les secteurs qui ne sont pas encore écrits dans le bloc de mémoire adressé en alternative actuel sont écrits avec les contenus des secteurs correspondants du nouveau bloc de mémoire affecté, et un compteur d'effacements est associé à chaque bloc de mémoire pour le nombre de ses effacements,
**caractérisé en ce**
**que** jusqu'à ce qu'une valeur de seuil donnée d'un compteur d'effacements soit atteinte, à chaque fourniture d'une bloc de mémoire alternatif, le bloc de mémoire sur la même puce de mémoire flash ayant une
faible valeur du compteur d'effacements est recherché, en cas de dépassement de la valeur de seuil donnée dans toutes les puces de mémoire flash, un bloc de mémoire ayant une faible valeur du compteur d'effacements est recherché et le bloc de mémoire trouvé est mis à disposition en tant que bloc de mémoire alternatif.

2. Procédé selon la revendication 1, **caractérisé en ce que** lors de la copie de secteurs dans un bloc de mémoire adressé en alternative à l'intérieur de la même puce de mémoire flash, une instruction de copie interne est utilisée.

3. Procédé selon la revendication 1, **caractérisé en ce que** lors de la copie de secteurs dans un bloc de mémoire adressé en alternative à l'extérieur de la même puce de mémoire flash, une mémoire tampon supplémentaire est utilisée.

4. Procédé selon la revendication 1, **caractérisé en ce que** la valeur de seuil donnée est égale à environ 90 % de la fréquence d'effacement-maximale autorisée.

5. Procédé selon la revendication 1, **caractérisé en ce que** la transposition d'adresse est effectuée par le biais d'une table d'association d'adresses de bloc de mémoire logiques à réelles dans laquelle sont également gérés les compteurs d'effacement.

6. Procédé selon la revendication 1, **caractérisé en ce que** le compteur d'effacement d'un bloc de mémoire est séparé en une partie de poids faible et une partie de poids fort et seule la partie de poids fort est utilisée pour la recherche des blocs de mémoire alternatifs.

7. Procédé selon la revendication 1, **caractérisé en ce qu'**un bloc de mémoire alternatif ayant une faible valeur du compteur d'effacements est également recherché dans toutes les puces de mémoire flash lorsque plus aucun autre bloc effacé faisant office de bloc tampon n'est disponible sur la même puce de mémoire flash.
